# FASCICULE DE BREVET EUROPEEN

(11) **EP 0 455 562 B1**
(45) Date de publication et mention de la délivrance du brevet: **28.06.1995**
(21) Numéro de dépôt: 91420045.6
(22) Date de dépôt: 11.02.1991
(51) Int. Cl.: G01R 31/02, G01R 31/12, H02B 13/02, G02B 6/36

(54) **Disposiif de détection d'un arc interne à une installation électrique blindée**
Anordnung zur Feststellung interner Funkenüberschläge in einer abgeschirmten elektrischen Installation
Internal spark detection device for an electrically shielded installation

(30) Priorité: 26.02.1990 FR 9002477
(43) Date de publication de la demande: 06.11.1991
(73) Titulaire: SCHNEIDER ELECTRIC SA, 92100 Boulogne Billancourt (FR)
(72) Inventeur: Giboulet, André, F-38050 Grenoble (FR); Maffioletti, Bruno, I-24100 Bergamo (IT); Giudici, Ettore, I-24100 Bergamo (IT); Allevi, Massimo, I-24100 Bergamo (IT); Codazzi, Antonio, I-24100 Bergamo (IT)
(74) Mandataire: Ritzenthaler, Jacques

(56) Documents cités:
- EP-A- 0 115 843
- BE-A- 505 420
- CH-A- 665 313
- DE-A- 2 447 240
- DE-A- 3 612 090
- ELEKTROTECHNISCHE ZEITSCHRIFT, vol. 98, no. 7, juillet 1977, pages 491-494; P.GEHRMANN: "Ortung von elektrischen Überschlägen in metallgekapselten SF6-Hochspannungsanlagen"
- JOURNAL OF LIGHTWAVE TECHNOLOGY, vol. 7, no. 7, juillet 1989, pages 1029-1032;K. MUTO: "Electric-discharge sensor utilizing fluorescent optical fiber"

## Description

L'invention est relative à un détecteur d'arc pour une installation électrique à isolation gazeuse ayant une enceinte étanche allongée remplie d'un gaz à rigidité diélectrique élevée, comprenant un capteur optique de lumière disposé dans ladite enceinte et une fibre optique de transmission du signal lumineux fourni par le capteur à un dispositif de traitement disposé à l'extérieur de l'enceinte.

Un amorçage interne peut provoquer d'importants dég^ts dans une installation électrique, par exemple dans un poste blindé, lorsque le défaut n'est pas détecté et éliminé rapidement et il est connu de répartir des cellules photoélectriques à l'intérieur du poste pour détecter l'apparition d'un arc en un point quelconque du poste. Ces systèmes sont compliqués et d'une fiabilité incertaine.

Un autre détecteur d'arc connu d'après le document CH-A-665 313, fait usage d'une fibre optique s'étendant à l'intérieur du poste pour collectionner la lumière émise à l'intérieur du poste et la transmettre à une unité de traitement qui pilote le déclenchement du disjoncteur de protection. La sensibilité de ce détecteur est limitée et la présence de la fibre dans le poste impose des contraintes et affecte la rigidité diélectrique.

Un dispositif de détection d'arc également connu d'après le document DE-A-3 612 090 comporte un capteur optique de lumière qui est disposé dans l'enceinte, qui traverse cette enceinte d'une manière étanche et qui est relié à une fibre optique de transmission ; un tel dispositif ne peut fonctionner correctement que si toutes les faces internes de l'enceinte sont polies de manière à réfléchir la lumière engendrée par l'arc.

Par ailleurs, l'utilisation d'un prisme pour dévier les rayons lumineux est également connue depuis fort longtemps.

La présente invention a pour but de permettre la réalisation d'un détecteur d'arc simple, capable de surveiller des volumes importants du poste sans affaiblir la rigidité diélectrique, en disposant un prisme dans l'enceinte allongée et en orientant ce prisme par rapport à l'axe longitudinal de l'enceinte.

Le détecteur d'arc selon l'invention est décrit dans la revendication 1.

Seule une faible partie de la tige pénètre dans l'enceinte, mais cette partie est taillée pour capter des rayons lumineux de toute direction, notamment des rayons parallèles à la paroi de l'enceinte qui frappent perpendiculairement la tige. Dans une enceinte allongée, telle qu'un jeu de barres, un capteur unique peut surveiller une grande longueur ou même toute la longueur du jeu de barres, si l'on prend soin d'éviter toute cloison interne opaque et en particulier si les isolateurs support de la barre présentent des orifices de passage de la lumière.

La face de réflexion de la tige est de préférence inclinée de 45° sur l'axe de la tige de manière à réfléchir un rayon perpendiculaire dans la direction de l'axe de la tige vers l'extérieur de l'enceinte traversée par la tige. La tige est avantageusement de section circulaire avec une face tronconique de réflexion en saillie ou en creux. La hauteur de cette face tronconique correspond sensiblement à la hauteur de saillie interne de la tige et le capteur optique est de préférence solidaire d'une paroi supérieure de l'enceinte.

D'autres avantages et caractéristiques ressortiront plus clairement de la description qui va suivre d'un mode particulier de réalisation de l'invention, donné à titre d'exemple non limitatif et représenté aux dessins annexés dans lesquels:

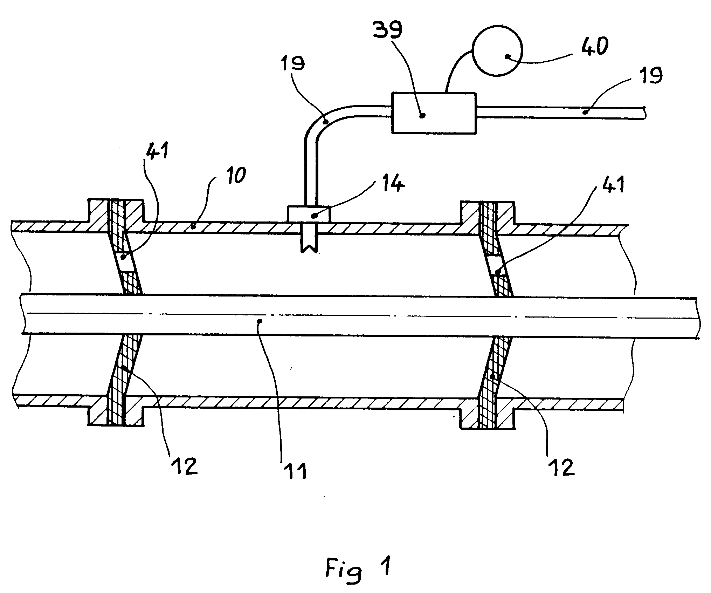

la figure 1 est une vue schématique en coupe d'un jeu de barres équipé d'un détecteur d'arc selon l'invention,
la figure 2 est une vue à échelle agrandie du détecteur selon la figure 1, représenté sur la demi-vue de droite accouplé à la fibre optique et sur la demi-vue de gauche avant accouplement de la fibre.

Sur les figures un jeu de barres d'un poste blindé comporte une enceinte étanche à paroi cylindrique 10, remplie d'un gaz à rigidité diélectrique élevée, tel que l'hexafluorure de soufre et contenant une barre conductrice 11, supportée coaxialement par des isolateurs support 12 échelonnés le long de la barre 11. Dans un orifice fileté 13, ménagé dans la paroi 10 de l'enceinte ou dans un manchon soudé à cette paroi est vissé un détecteur d'arc 14, qui traverse d'une manière étanche la paroi 10. Le détecteur 14 est constitué par un raccord 15 ayant une partie antérieure filetée 16, se vissant dans la paroi 10, un collet intermédiaire 17 à six pans de préhension et une partie postérieure filetée 18 de raccordement par vissage d'un conducteur optique 19. Le raccord 15 est traversé par un conduit axial 20 recevant dans la partie antérieure 16, à emboîtement étanche par deux joints toriques 21 et/ou collage 22, une tige 23 en verre ou en matière synthétique transparente isolante. Dans la partie postérieure 18 du conduit 20 de section amoindrie est emboîtée en alignement de la tige 23, l'extrémité dénudée 24 d'une fibre optique 25. Le conducteur optique 19 est fixé à l'aide d'un manchon 26 enfilé sur l'extrémité denudée 24 et sur un tronçon de la gaine 27 de la fibre 25. Ce manchon 26 présente un collet 28 maintenu en appui de la face de la partie postérieure 18 par un écrou 29, vissé sur cette partie postérieure filetée 18. Un joint torique 30 est interposé entre le collet 28 et la face d'appui 18. L'étanchéité entre le raccord 15 et la paroi 10 est réalisée par des joints toriques 31 de la manière usuelle. Entre la face terminale 32 de la fibre optique 25 et l'extrémité arrondie 33 en regard de la tige 23 subsiste un intervalle 34 de raccordement tronconique. Le raccord 15 en métal est, en position de fixation du détecteur d'arc 14, légèrement en retrait de la paroi 10 afin de ne pas perturber l'isolation électrique,tandis que la tige 23 fait saillie du raccord 15 et de la paroi 10 en pénêtrant sur une hauteur réduite h à l'intérieur de l'enceinte. Cette faible saillie d'une pièce isolante 23 n'affecte pas la tenue diélectrique.

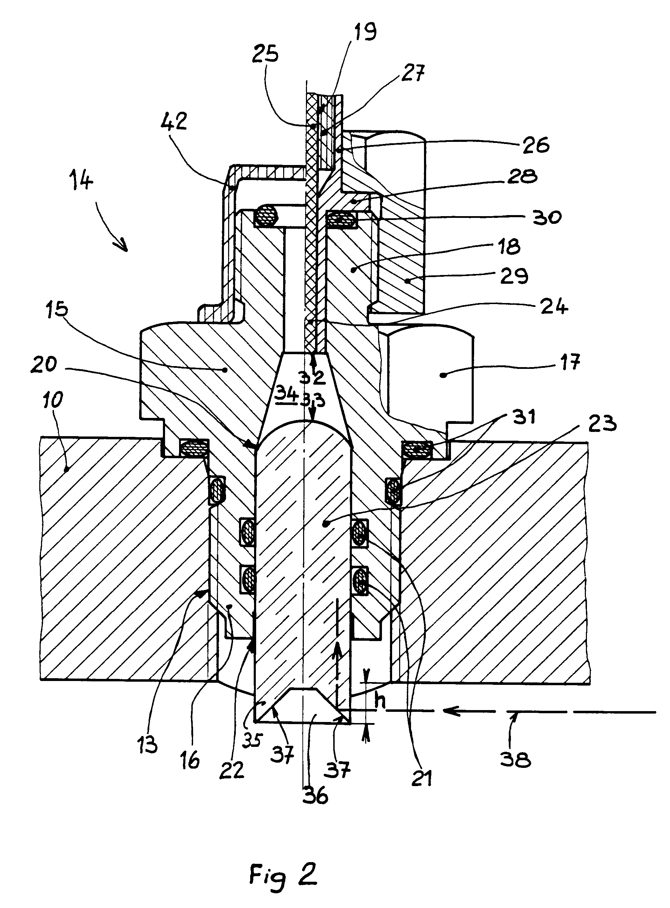

Dans l'exemple illustré par la figure 2 la tige 23 est de section cylindrique et l'extrémité 35 en saillie interne présente une cavité interne tronconique en entonnoir 36 dont la profondeur correspond sensiblement à la hauteur de saillie h. Les faces tronconiques 37 sont inclinées d'environ 45° sur l'axe de la tige 23 et constituent des faces de réflexion d'un rayon lumineux 38, notamment d'un rayon parallèle à la paroi 10, qui est dévié de 90° dans la direction de l'axe de la tige 23 vers la fibre optique 25. La tige 23 capte également les rayons orientés différemment, en particulier dans l'axe de la tige 23.

Le conducteur optique 19 est connecté à un dispositif de traitement 39, qui peut être commun à plusieurs capteurs 14 et qui transforme les signaux lumineux transmis par les conducteurs optiques 19 en un ordre de déclenchement ou de signalisation 40 d'un défaut. En prévoyant dans les isolateurs support 12 des orifices 41 de passage des rayons lumineux 38 un même capteur 14 peut surveiller plusieurs compartiments du jeu de barres ou de l'enceinte. On comprend que les rayons 38, émis d'un point éloigné du capteur 14, sont sensiblement parallèles à la paroi 10 et frappent perpendiculairement la tige 23. Les faces de réflexion 37 captent ces rayons 38 qui en l'absence de telles faces 37 traverseraient simplement la tige 23. Les faces de réflexion 37 peuvent être en saillie convexe et/ou être constituées par des facettes ou des faces planes orientées dans l'axe de la barre 11. Le capteur 14 est avantageusement fixé à la paroi supérieure 10 afin d'être orienté vers le bas et d'éviter des dépôts formant un écran au passage de la lumière. La tige 23 est de préférence en matière plastique transparente, mais d'autres matériaux sont utilisables et la liaison entre la tige 23 et la fibre optique peut être réalisée par aboutement des deux extrémités 32,33 en regard. Le conducteur optique 19 d'un type standard peut être facilement mis en place ou démonté après dévissage de l'écrou 29. La partie gauche de la figure 2 montre le capteur 14 avant le raccordement du conducteur optique 19 avec un capot 42 de protection vissé sur la partie postérieure 18 afin d'éviter toute détérioration pendant le transport. Après montage du poste il suffit d'enlever le capot 42 et de fixer le conducteur optique 19 par emboîtement de l'extrémité 24 et serrage de l'écrou 29.

Le capteur 14 ne pénétre quasiment pas à l'intérieur de l'enceinte et il peut donc être fixé en un point quelconque le plus approprié. Un nombre limité de capteurs 14 et de ce fait d'orifices 13 dans la paroi 10 permet une surveillance complète de l'installation. La section de ces orifices 13 peut être faible et l'étanchéité ainsi que la fixation de la tige 23, qui traverse la paroi 10 perpendiculairement, peuvent bien entendu être réalisées différemment.

## Revendications

1. Détecteur d'arc pour une enceinte étanche allongée d'une installation électrique à isolation gazeuse remplie d'un gaz à rigidité diélectrique élevée, ayant un axe longitudinal et une paroi confinant ladite enceinte comprenant un capteur optique (14) de lumière disposé dans ladite enceinte et constitué par une tige (23) transparente en verre ou en matière synthétique isolante, qui traverse d'une manière étanche la paroi (10) de ladite enceinte, une fibre optique (25) de transmission du signal lumineux fourni par le capteur (14), un dispositif de traitement (39) disposé à l'extérieur de l'enceinte et recevant le signal transmis par la fibre optique (25), ladite tige (23) ayant une extrémité (35) faisant faiblement saillie vers l'intérieur de l'enceinte caractérisé en ce que ladite extrémité comporte une face de réflexion (37) inclinée d'environ 45° sur ledit axe longitudinal et apte à réfléchir dans la direction de ladite tige (23) vers l'extérieur de l'enceinte, un rayon lumineux (38) sensiblement parallèle audit axe longitudinal.

2. Détecteur d'arc selon la revendication 1, caractérisé en ce que ladite tige (23) est cylindrique et que ladite extrémité (35) est taillée en tronc de cône (37) coaxial à ladite tige, formant une cavité en entonnoir dans ladite extrémité (35), et ayant un angle au sommet voisin de 90°.

3. Détecteur d'arc selon la revendication 2, caractérisé en ce que ladite cavité s'étend sensiblement sur la hauteur h de saillie de la tige (23) dans l'enceinte.

4. Détecteur d'arc selon l'une quelconque des revendications précédentes, caractérisé en ce que la tige (23) rectiligne traverse perpendiculairement la paroi (10) de l'enceinte avec interposition d'un joint d'étanchité (21) et que la fibre optique (25) est en regard et dans le prolongement de l'extrémité externe (33) de ladite tige (23) pour transmettre la lumière captée vers le dispositif de traitement (39).

5. Détecteur d'arc selon l'une quelconque des revendications précédentes pour un jeu de barres (11) ayant des isolateurs support (12) échelonnés et intercalés entre la barre et la gaine allongée, caractérisé en ce que lesdits isolateurs (12) présentent des orifices (41) de passage de rayons lumineux (38) s'étendant parallèlement audit axe longitudinal.

## Patentansprüche

1. Lichtbogenwächter für ein gasdichtes, längliches Gehäuse einer gasisolierten elektrischen Anlage, das mit einem Gas hoher dielektrischer Festigkeit gefüllt ist und eine Längsachse sowie eine das genannte Gehäuse abschließende Wand aufweist, wobei der Lichtbogenwächter ein in das genannte Gehäuse eingesetztes lichtempfindliches Element (14), das aus einem die Wand (10) des genannten Gehäuses gasdicht durchragenden Stab (23) aus Glas oder einem isolierenden Kunststoff besteht, eine Lichtleitfaser (25) zur Übertragung des von dem lichtempfindlichen Element (14) gelieferten Lichtsignals sowie eine außerhalb des Gehäuses angeordnete und das von der Lichtleitfaser (25) übertragene Signal aufnehmende Signalverarbeitungsschaltung (39) umfaßt, und der genannte Stab (23) ein Ende (35) aufweist, daß geringfügig in den Innenraum des Gehäuses hineinragt, dadurch gekennzeichnet, daß das genannte Ende eine in Bezug auf die genannte Längsachse um etwa 45° geneigte Reflexionsfläche (37) aufweist, die in der Lage ist, einen annähernd parallel zur genannten Längsachse verlaufenden Lichtstrahl (38) in die Ebene des genannten Stabs (23) zu reflektieren und aus dem Gehäuse herauszuführen.

2. Lichtbogenwächter nach Anspruch 1, dadurch gekennzeichnet, daß der genannte Stab (23) zylindrisch geformt und das genannte Ende (35) in Form eines koaxial zum genannten Stab angeordneten Kegelstumpfes (37) ausgeführt ist, der eine trichterförmige Ausbuchtung in dem genannten Ende (35) bildet und einen Spitzenwinkel von etwa 90° aufweist.

3. Lichtbogenwächter nach Anspruch 2, dadurch gekennzeichnet, daß die Tiefe der genannten Ausbuchtung annähernd der Höhe h des in das Gehäuse ragenden Vorsprungs des Stabs (23) entspricht.

4. Lichtbogenwächter nach irgendeinem der vorhergehenden Ansprüche, dadurch gekennzeichnet, daß der geradlinige Stab (23) die Wand (10) des Gehäuses unter Einfügung einer Dichtung (21) durchragt und daß die Lichtleitfaser (25) in der Verlängerung des äußeren Endes (33) des genannten Stabs (23) gegenüber diesem Ende angeordnet ist, um das aufgenommene Lichtsignal an die Signalverarbeitungsschaltung (39) weiterzuleiten.

5. Lichtbogenwächter nach irgendeinem der vorhergehenden Ansprüche für eine Sammelschienenanordnung (11) mit zwischen der Schiene und der länglichen Umhüllung eingefügten Stützisolatoren (12), dadurch gekennzeichnet, daß die genannten Stützisolatoren (12) Durchtrittsöffnungen (41) für parallel zur genannten Längsachse verlaufende Lichtstrahlen (38) aufweisen.

## Claims

1. An arc detector for an elongated sealed enclosure of a gas-insulated electrical installation filled with a high dielectric strength gas having a longitudinal axis and a wall bounding said enclosure comprising an optic light sensor (14) located in said enclosure and formed by a transparent rod (23) made of glass or synthetic insulating material, which passes tightly through the wall (10) of said enclosure, an optic fiber (25) for transmission of the light signal supplied by the sensor (14), a processing device (39) located outside the enclosure and receiving the signal transmitted by the optic fiber (25), said rod (23) having an end (35) protruding slightly into the enclosure, characterized in that said end comprises a reflecting face (37) inclined approximately 45° on said longitudinal axis and able to reflect a light ray (38) appreciably parallel to said longitudinal axis in the direction of said rod (23) to the outside of the enclosure.

2. The arc detector according to claim 1, characterized in that said rod (23) is cylindrical and that said end (35) is shaped as a frustum (3 ) coaxial to said rod, forming a funnel-shaped cavity in said end (35), and having an apex angle close to 90°.

3. The arc detector according to claim 2, characterized in that said cavity extends appreciably over the protrusion height h of the rod (23) inside the enclosure.

4. The arc detector according to any one of the above claims, characterized in that the straight rod (23) passes perpendicularly through the wall (10) of the enclosure with an O-ring (21) interposed and that the optic fiber (25) is facing and in the extension of the external end (33) of said rod (23) to transmit the light captured to the processing device (39).

5. The arc detector according to any one of the above claims for a busbar (11) having support insulators (12) located at intervals and inserted between the bar and the elongated sleeve, characterized in that said insulators (12) present orifices (41) for the passage of light rays (38) extending parallel to said longitudinal axis.
